# EUROPÄISCHE PATENTANMELDUNG

(11) **EP 1 672 319 A1**
(43) Veröffentlichungstag der Anmeldung: **21.06.2006**
(21) Anmeldenummer: 05110913.0
(22) Anmeldetag: 18.11.2005
(51) Int. Cl.: G01C 21/26, G01C 19/00, G01C 25/00, H05K 3/30

(54) **Navigationscomputer mit einem gyro-sensor**

(30) Priorität: 17.12.2004 DE 102004060977
(71) Anmelder: SIEMENS AKTIENGESELLSCHAFT, 80333 München (DE)
(72) Erfinder: Nagel, Thomas, 35796, Gräveneck (DE); Schmidt, Karsten, 35745, Herborn-Seelbach (DE)

(57) **Zusammenfassung**

Die Erfindung betrifft einen Navigationscomputer mit einem Gerätegehäuse (7) für den Festeinbau in ein Kraftfahrzeug (1) unter einer von der Horizontalen bezüglich einer Grundfläche (5) des Kraftfahrzeuges abweichenden Einbaulage, wobei das Gerätegehäuse (7) einen in einem Bauelementegehäuse (12) angeordneten Gyro-Sensor (11), der eine Vorzugslage parallel zu einer ebenen Fläche (13) des Bauelementegehäuses (12) aufweist, und eine Leiterplatte (8) mit elektronischen Bauelementen (9) enthält und die ebene Fläche (13) des Bauelementegehäuses (12) bezüglich der Einbaulage des Gerätegehäuses (7) verkippt ist. Erfindungsgemäß wird vorgeschlagen, dass der Gyro-Sensor (11) auf der die elektronischen Bauelemente (9) tragenden Leiterplatte (8) mittels eines Abstandselementes (10) so angeordnet ist, dass die zur Vorzugslage parallel verlaufende ebene Fläche (13) des Bauelementegehäuses (12) unter einem von Null Grad verschiedenen Winkel zur Leiterplatte (8) verläuft.

## Beschreibung

Die Erfindung betrifft einen Navigationscomputer mit einem Gerätegehäuse für den Festeinbau in ein Kraftfahrzeug unter einer von der Horizontalen bezüglich einer Grundfläche des Kraftfahrzeuges abweichenden Einbaulage, wobei das Gerätegehäuse einen Gyro-Sensor mit einem in einem Bauelementegehäuse angeordneten Gyro-Sensorelement, das eine Vorzugslage parallel zu einer ebenen Fläche des Bauelementgehäuses aufweist, und eine Leiterplatte mit elektronischen Bauelementen enthält und die ebene Fläche des Bauelementgehäuses bezüglich der Einbaulage des Gerätegehäuses verkippt ist. Ein derartiger Navigationscomputer ist aus der DE 199 62 823 A1 bekannt.

Navigationscomputer für Kraftfahrzeuge werden häufig in einer Mittelkonsole des Kraftfahrzeuges eingebaut. Der Navigationscomputer weist dabei ein Gerätegehäuse auf, in dem eine Leiterplatte mit den entsprechenden elektronischen Bauelementen angeordnet ist, wie beispielsweise einem Mikroprozessor und dem zugehörigen Arbeitsspeicher. Die Bestimmung der Position des Kraftfahrzeuges erfolgt üblicherweise sowohl durch Satellitennavigation als auch durch Koppelnavigation. Für die Koppelnavigation werden Informationen zur zurückgelegten Wegstrecke und zu Drehbewegungen des Kraftfahrzeuges benötigt, die von entsprechenden Sensoren zur Verfügung gestellt werden.

Zur Ermittlung der Drehbewegung wird ein Gyro-Sensor eingesetzt, bei dem ein Gyro-Sensorelement in einem Gerätegehäuse verbaut ist. Gyro-Sensoren messen eine Drehbewegung um eine Drehachse und weisen daher eine Vorzugslage senkrecht zu dieser Drehachse auf. Um im Kraftfahrzeug eine Drehbewegung um die Hochachse zu bestimmen, muss die Vorzugslage des Gyro-Sensors bzw. des Gyro-Sensorelements also horizontal zur Grundfläche ausgerichtet sein. Größere Abweichungen von dieser Ausrichtung führen zu einer fehlerhaften Bestimmung des Drehwinkels und damit zu einer fehlerhaften Positionsbestimmung.

Da das Gerätegehäuse des Navigationscomputers bei Einbau in die Mittelkonsole in der Regel unter einer von der Horizontalen bezüglich einer Grundfläche des Kraftfahrzeuges abweichenden Einbaulage verbaut wird, muss der Gyro-Sensor verkippt zum Gerätegehäuse verbaut werden, um diese von der Horizontalen abweichende Einbaulage des Gerätegehäuses zu kompensieren.

Nach der eingangs genannten DE 199 62 823 A1 wird der Gyro-Sensor daher winkelverstellbar in der Gehäusewand des Navigationscomputers angeordnet. Hierdurch wird erreicht, dass der Navigationscomputer für verschiedene Einbaulagen geeignet ist, wobei die Einbaulage in der Regel durch eine Neigung der Mittelkonsole des Kraftfahrzeuges vorgegeben ist. Durch Verstellung des Kippwinkels des Gyro-Sensors (relativ zum Gerätegehäuse) kann dessen Lage an verschiedene Einbaulagen des Gerätegehäuses angepasst werden.

Nachteilig ist hierbei jedoch, dass bei jedem Navigationscomputer eine Einstellung des Kippwinkels des Gyro-Sensors erfolgen muss, selbst dann, wenn eine größere Geräteanzahl zum Einbau in den gleichen Fahrzeugtyp vorgesehen ist.

Aufgabe der Erfindung ist es daher, einen Navigationscomputer anzugeben, bei dem die Einbaulage des Gyro-Sensors an die Einbaulage des Gerätegehäuses für einen bestimmten Fahrzeugtyp angepasst ist.

Die Aufgabe wird durch einen Navigationscomputer mit den Merkmalen des Anspruchs 1 gelöst. Vorteilhafte Ausgestaltungen sind in den Unteransprüchen angegeben.

Bei der erfindungsgemäßen Ausgestaltung wird der Gyro-Sensor auf der elektronische Bauelemente tragenden Leiterplatte angeordnet. Hierdurch entfallen ansonsten erforderliche Kabelverbindungen zwischen dem Gyro-Sensor und der Leiterplatte.

Das eigentliche Gyro-Sensorelement ist von einem Bauelementegehäuse umgeben, wobei eine ebene Fläche des Bauelementgehäuses, in der Regel die Grundfläche, parallel zur Vorzugslage des Gyro-Sensorelements verläuft und horizontal ausgerichtet sein muss. Um nun die horizontale Ausrichtung des Gyro-Sensors zu gewährleisten, ist dieser in der erfindungsgemäßen Ausgestaltung mittels eines Abstandselementes auf der Leiterplatte so angeordnet, dass die zur Vorzugslage parallel verlaufende ebene Fläche des Bauelementgehäuses unter einem von 0°verschiedenen Winkel zur Leiterplatte verläuft. Mit anderen Worten ist das Bauelementgehäuse des Gyro-Sensors gegenüber der Leiterplatte verkippt angeordnet. Die Verkippung wird dabei so gewählt, dass die von der Horizontalen abweichende Einbaulage des Gerätegehäuses im Kraftfahrzeug kompensiert wird. Durch diese Ausgestaltung entfällt die ansonsten erforderliche manuelle Justierung des Gyro-Sensors. Für unterschiedliche Fahrzeugtypen, die in der Regel eine unterschiedliche Einbaulage des Gerätegehäuses aufweisen, werden in der Fertigung dann lediglich unterschiedliche Abstandselemente vorgesehen, die unterschiedliche Kippwinkel des Bauelementegehäuses des Gyro-Sensors bezüglich der Leiterplatte zur Kompensation der unterschiedlichen Einbaulagen aufweisen.

Vorzugsweise ist das Abstandselement keilförmig ausgebildet und der Keilwinkel entspricht der Abweichung der Einbaulage des Gerätegehäuses von der Horizontalen bezüglich der Grundfläche des Kraftfahrzeuges. Hierdurch kann eine vergleichsweise großflächige Auflage des Abstandselementes sowohl auf der Leiterplatte als auch gegenüber dem Bauelementegehäuse des Gyro-Sensors erreicht werden.

In einer weiteren Ausgestaltung weist das Abstandselement elektrische Anschlusselemente auf, die mit Leiterbahnen der Leiterplatte verbunden sind. Somit findet also eine elektrische Verbindung des Gyro-Sensors mit der Leiterplatte über die entsprechenden elektrischen Anschlusselemente des Abstandselementes statt. Hierdurch können unabhängig vom Kippwinkel und von den Abmessungen des Abstandselementes standardmäßige Gyro-Sensoren eingesetzt werden.

Insbesondere kann das Abstandselement Rastelemente aufweisen, die in Ausnehmungen der Leiterplatte eingeklippst sind. Auf diese Weise wird eine besonders einfache und sichere Verbindung des Abstandselementes mit der Leiterplatte erreicht.

In einer anderen Ausgestaltung ist das Abstandselement als SMT(Surface Mount Technology)-Bauteil ausgebildet. Die Ausbildung des Abstandselementes als SMT-Bauteil hat den Vorteil, dass bei der maschinellen Bestückung der Leiterplatte auch das Abstandselement mit aufgebracht werden kann und die Verlötung der elektrischen Anschlusselemente mit den Leiterbahnen der Leiterplatte im Reflow-Verfahren möglich ist.

In einer anderen Ausführungsform weist das Abstandselement Fixierstifte auf. Die Fixierstifte greifen in entsprechende Ausnehmungen der Leiterplatte ein und gewährleisten eine gleich bleibende Positionierung des Abstandselementes.

Zur Befestigung des Bauelementgehäuses des Gyro-Sensors auf dem Abstandselement ist es vorteilhaft, wenn das Abstandselement Rastelemente zur Befestigung des Bauelementgehäuses aufweist. Hierdurch ist eine schnelle und sichere Verbindung des Abstandselementes mit dem Bauelementgehäuse gewährleistet.

Eine sichere elektrische Verbindung zwischen den elektrischen Anschlusselementen des Abstandselementes und elektrischen Anschlusselementen des Bauelementegehäuses kann insbesondere dadurch erzielt werden, dass das Abstandselement selbstsichernde Schneidklemmen aufweist.

Die Erfindung wird nachfolgend anhand eines Ausführungsbeispiels und der Zeichnung näher erläutert. Es zeigen:
- Figur 1: eine schematische Darstellung der Anordnung eines Gerätegehäuses eines Navigationscomputers in einem Kraftfahrzeug,
- Figur 2: eine Explosionsdarstellung der Anordnung eines Abstandselementes und eines Bauelementegehäuses auf einer Leiterplatte,
- Figur 3: eine Ausführungsform des Abstandselementes als SMT-Bauteil,
- Figur 4: eine weitere Ausführungsform des Abstandselementes als SMT-Bauteil mit zusätzlichen Fixierstiften,
- Figur 5: eine weitere Ausgestaltung des Abstandselementes mit elektrischen Anschlussstiften,
- Figur 6: eine weitere Explosionsdarstellung der Anordnung eines Abstandselementes und eines Bauelementegehäuses auf einer Leiterplatte.

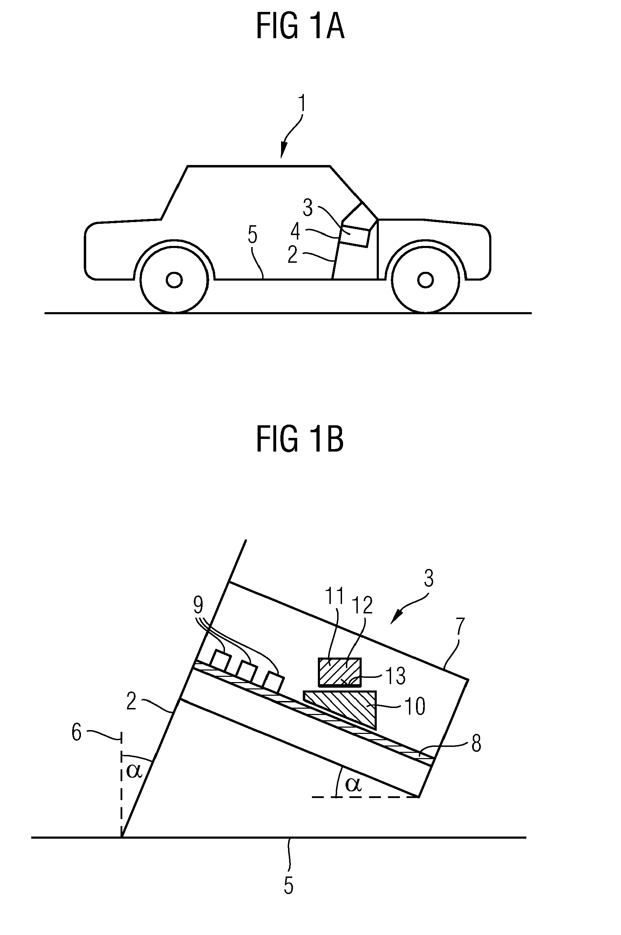

Figur 1a zeigt schematisch ein Kraftfahrzeug 1 mit einer Mittelkonsole 2, in die ein Navigationscomputer 3 eingebaut ist. Der Navigationscomputer 3 ist mit einer Frontfläche 4 parallel zur Mittelkonsole 2 ausgerichtet. Somit ergibt sich durch die Neigung der Mittelkonsole 2 eine von der Horizontalen bezüglich der Grundfläche 5 des Kraftfahrzeuges 1 abweichende Einbaulage des Navigationscomputers 3.

Figur 1b zeigt einen Ausschnitt aus dem Kraftfahrzeug gemäß Figur 1a, wobei insbesondere die Mittelkonsole 2, der Navigationscomputer 3 und die Grundfläche 5 dargestellt sind. Auf Grund der Neigung der Mittelkonsole 2 gegenüber der Senkrechten 6, die der Hochachse des Fahrzeugs entspricht, zur Grundfläche 5 um den Winkel *α* ergibt sich eine von der Horizontalen bezüglich der Grundfläche 5 des Kraftfahrzeuges abweichende Einbaulage des Gerätegehäuses 7 des Navigationscomputers 3.

In dem Gerätegehäuse 7 ist eine Leiterplatte 8 angeordnet, die elektronische Bauelemente 9 trägt. Weiterhin ist auf der Leiterplatte 8 ein Abstandselement 10 angeordnet, auf dem seinerseits ein Gyro-Sensor 11 angebracht ist. Der Gyro-Sensor 11 weist ein Bauelementegehäuse 12 mit einer ebenen Fläche 13 auf.

Ein Gyro-Sensorelement ist im Bauelementegehäuse 12 des Gyro-Sensor 11 mit einer Vorzugslage, die senkrecht zur Drehachse des zu bestimmenden Drehwinkels verläuft, parallel zur ebenen Fläche 13 des Bauelementgehäuses 12 angeordnet. Somit ist bei der Montage des Gyro-Sensors 11 sicherzustellen, dass die ebene Fläche 13 horizontal, das heißt parallel zur Grundfläche 5, verläuft, um eine Drehung des Fahrzeugs um die Hochachse bestimmen zu können. Dies wird durch das Abstandselement 10 sichergestellt, das an den Neigungswinkel α der Einbaulage des Gerätegehäuses angepasst ist.

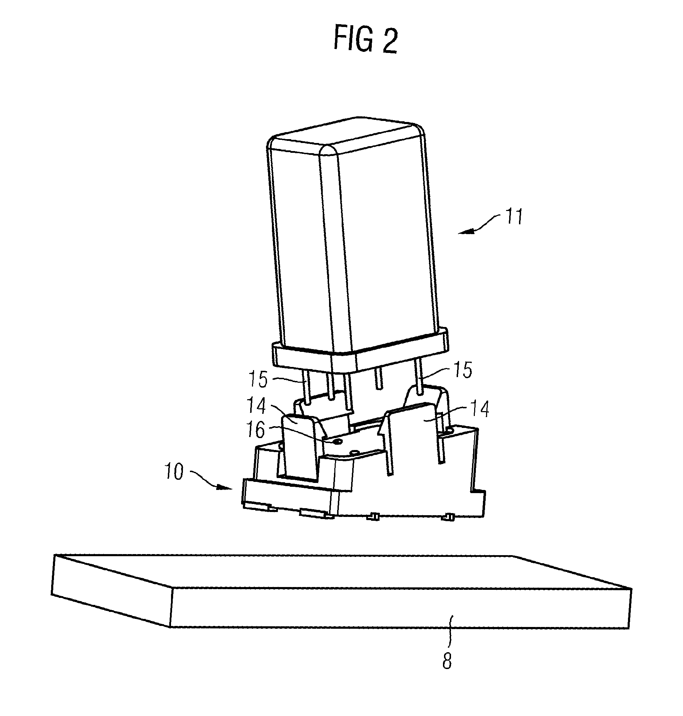

Figur 2 zeigt eine Explosionsdarstellung der Anordnung des Gyro-Sensors 11 auf der Leiterplatte 8 mittels des Abstandselementes 10. Das Abstandselement 10 ist gemäß Figur 2 als SMT-Bauelement ausgebildet und besteht im Wesentlichen aus einem Kunststoffmaterial. Mittels der Rastelemente 14 des Abstandselementes 10 kann der Gyro-Sensor 11 sicher mit dem Abstandselement 10 verbunden werden. Der Gyro-Sensor 11 weist elektrische Anschlusselemente 15 auf, die in als Schneidklemmen ausgebildete Aufnahmen 16 eintauchen.

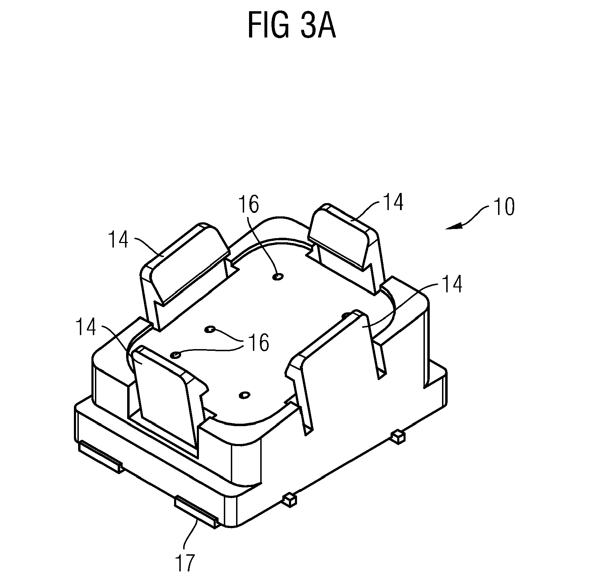

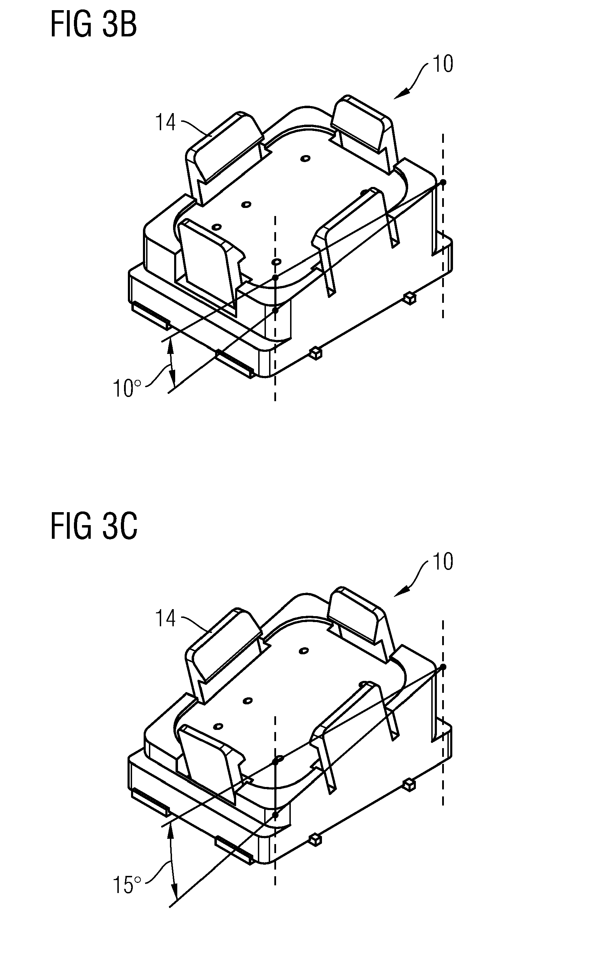

In Figur 3 ist das Abstandselement 10 separat dargestellt. Das Abstandselement 10 ist keilförmig ausgebildet, um eine entsprechende Schrägstellung des Gyro-Sensors 11 gegenüber der Leiterplatte 8 zu erreichen. Das Abstandselement 10 weist vier als Rasthaken ausgebildete Rastelemente 14 auf, die zur Befestigung des Gyro-Sensors 11 dienen. Die als Schneidklemmen ausgebildeten Aufnahmen 16 dienen zur elektrischen Kontaktierung des Gyro-Senros 11. Das Lochmuster der Aufnahmen 16 ist an das Muster der elektrischen Anschlusselemente 15 des Gyro-Sensors 11 angepasst. Die Schneidklemmen der Aufnahmen 16 sind elektrisch leitend mit Flächenkontaktelementen 17 verbunden, über die die elektrische Verbindung mit der Leiterplatte 8 hergestellt wird.

In den Figuren 3b und 3c sind Abstandselemente 10 mit verschiedenen Neigungswinkeln, nämlich 10° und 15°, dargestellt. Navigationssysteme, die für einen bestimmten Fahrzeugtyp vorgesehen sind, werden dabei mit einem einheitlichen Abstandselement desselben Neigungswinkels versehen. Unterschiedliche Fahrzeugtypen, die eine unterschiedliche Einbaulage des Navigationssystems erfordern, weisen dagegen unterschiedliche Abstandselemente mit unterschiedlichen Neigungswinkeln, wie beispielsweise in Figur 3b und 3c dargestellt, auf.

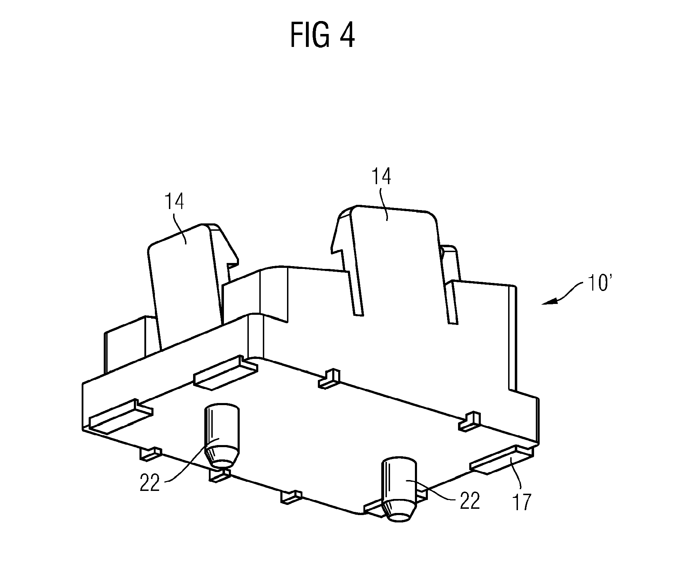

In Figur 4 ist ein Abstandselement 10' als SMT-Bauteil dargestellt, das zusätzlich Fixierstifte 22 aufweist, die in entsprechende Ausnehmungen der Leiterplatte 8 eingreifen.

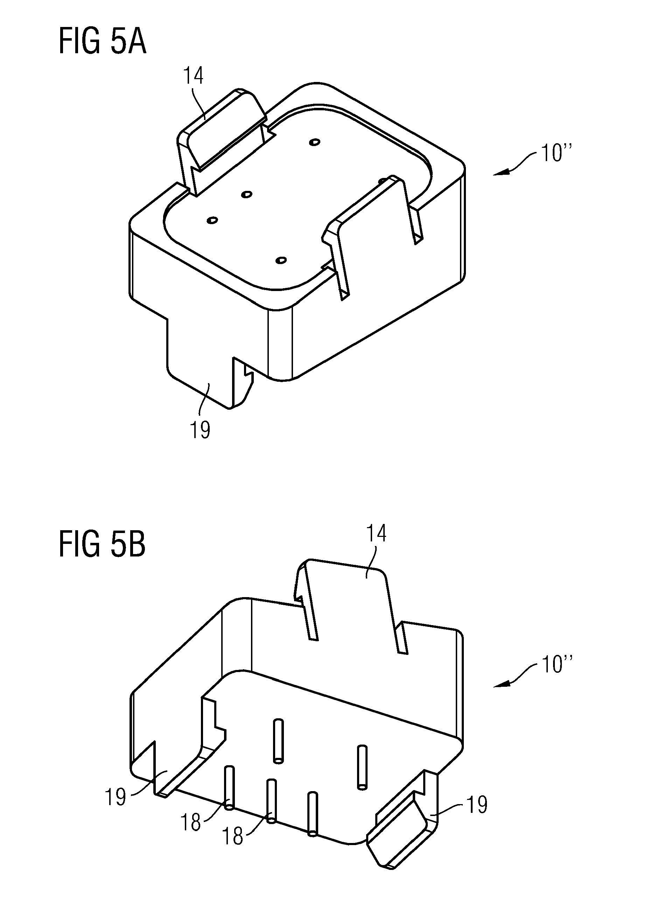

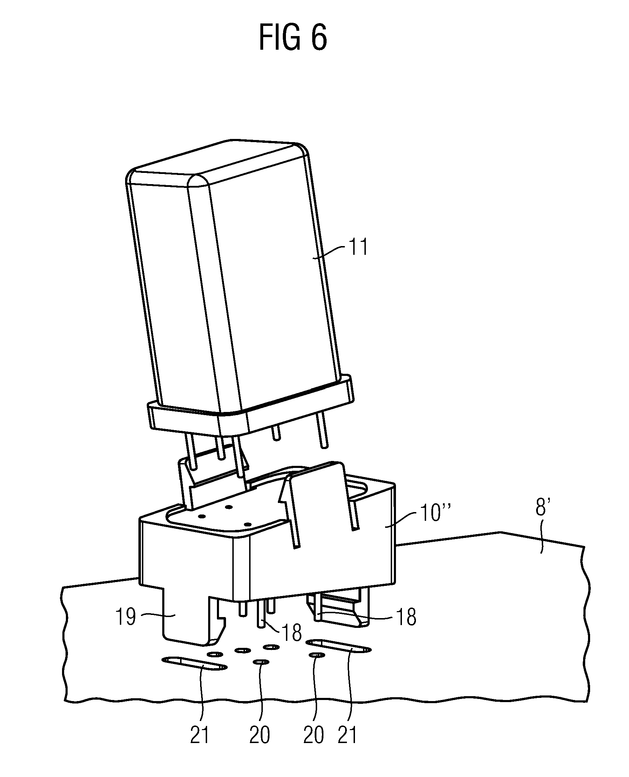

In Figur 5 ist eine weitere Ausführungsform eines Abstandselementes dargestellt. Das Abstandselement 10'' ist insbesondere für die Handbestückung von Leiterplatten ausgebildet. Das Abstandselement 10'' weist Anschlussstifte 18 für die elektrische Kontaktierung mit der Leiterplatte auf. Des Weiteren weist das Abstandselement 10" als Rasthaken ausgebildete weitere Rastelemente 19 für die Befestigung des Abstandselementes 10" auf einer Leiterplatte auf. Die Rastelemente 19 werden hierzu in entsprechende Ausnehmungen der Leiterplatte eingeklippst. Dies ist aus der Explosivdarstellung der Figur 6 näher ersichtlich. Die Leiterplatte 8' weist entsprechende Bohrungen 20 zur Aufnahme der Anschlussstifte 18 auf. Des Weiteren weist die Leiterplatte 8' Ausnehmungen 21 auf, in die die weiteren Rastelemente 19 eingeklippst werden.

Die Erfindung wurde anhand verschiedener Ausführungsbeispiele erläutert, wobei Abwandlungen insbesondere hinsichtlich der Befestigung oder der elektrischen Verbindung möglich sind, ohne den Grundgedanken der Erfindung zu verlassen.

## Patentansprüche

1. Navigationscomputer (3) mit einem Gerätegehäuse (7) für den Festeinbau in ein Kraftfahrzeug (1) unter einer von der Horizontalen bezüglich einer Grundfläche (5) des Kraftfahrzeuges (1) abweichenden Einbaulage, wobei das Gerätegehäuse (7) einen Gyro-Sensor (11) mit einem in einem Bauelementegehäuse (12) angeordneten Gyro-Sensorelement, das eine Vorzugslage parallel zu einer ebenen Fläche (13) des Bauelementegehäuses (12) aufweist, und eine Leiterplatte (8) mit elektronischen Bauelementen (9) enthält und die ebene Fläche (13) des Bauelementegehäuses (12) bezüglich des Gerätegehäuses (7) verkippt ist, **dadurch gekennzeichnet , dass** der Gyro-Sensor (11) auf der die elektronischen Bauelemente (9) tragenden Leiterplatte (8) mittels eines Abstandselementes (10) so angeordnet ist, dass die zur Vorzugslage parallel verlaufende ebene Fläche (13) des Bauelementegehäuses (12) unter einem von Null Grad verschiedenen Winkel zur Leiterplatte (8) verläuft.

2. Navigationscomputer (3) nach Anspruch 1, **dadurch gekennzeichnet , dass** das Abstandelement (10) keilförmig ausgebildet ist und der Keilwinkel der Abweichung der Einbaulage des Gerätegehäuses (7) von der Horizontalen bezüglich der Grundfläche (5) des Kraftfahrzeuges (1) entspricht.

3. Navigationscomputer (3) nach einem der vorhergehenden Ansprüche, **dadurch gekennzeichnet , dass** das Abstandselement (10) elektrische Anschlusselemente (Flächenkontaktelemente 17; Anschlussstifte 18) aufweist, die mit Leiterbahnen der Leiterplatte (8) verbunden sind.

4. Navigationscomputer (3) nach einem der vorhergehenden Ansprüche, **dadurch gekennzeichnet , dass** das Abstandselement (10) Rastelemente (19) aufweist, die in Ausnehmungen (21) der Leiterplatte (8') eingeklippst sind.

5. Navigationscomputer (3) nach einem der vorhergehenden Ansprüche, **dadurch gekennzeichnet , dass** das Abstandelement (10) als SMT-Bauteil ausgebildet ist.

6. Navigationscomputer (3) nach einem der vorhergehenden Ansprüche, **dadurch gekennzeichnet , dass** das Abstandelement (10) Fixierstifte (22) aufweist.

7. Navigationscomputer (3) nach einem der vorhergehenden Ansprüche, **dadurch gekennzeichnet , dass** das Abstandelement (10) Rastelemente (14) zur Befestigung des Bauelementegehäuses (12) aufweist.

8. Navigationscomputer (3) nach einem der vorhergehenden Ansprüche, **dadurch gekennzeichnet , dass** das Abstandselement (10) selbstsichernde Schneidklemmen zur elektrischen Kontaktierung des Gyro-Sensors (11) aufweist.
